# EUROPÄISCHE PATENTSCHRIFT

(11) **EP 1 597 733 B1**
(45) Veröffentlichungstag und Bekanntmachung des Hinweises auf die Patenterteilung: **02.12.2009**
(21) Anmeldenummer: 04711567.0
(22) Anmeldetag: 17.02.2004
(51) Int. Cl.: G11C 16/26

(54) **VERFAHREN ZUM AUSLESEN VON UNIFORM-CHANNEL-PROGRAM-FLASH MEMORY ZELLEN**
METHOD FOR READING UNIFORM CHANNEL PROGRAM (UCP) FLASH MEMORY CELLS
PROCEDE DE SELECTION DE CELLULES DE MEMOIRE FLASH-PROGRAMME DE CANAL UNIFORME

(30) Priorität: 27.02.2003 DE 10308856; 08.08.2003 DE 10336785
(43) Veröffentlichungstag der Anmeldung: 23.11.2005
(73) Patentinhaber: Infineon Technologies AG, 81669 München (DE)
(72) Erfinder: GRATZ, Achim, 01109 Dresden (DE); ROEHRICH, Mayk, 02826 Görlitz (DE); KNOBLOCH, Klaus, 01478 Weixdorf (DE)
(74) Vertreter: Hudler, Frank
(86) Internationale Anmeldenummer: PCT/DE2004/000297
(87) Internationale Veröffentlichungsnummer: WO 2004/077448

(56) Entgegenhaltungen:
- EP-A- 0 616 332
- EP-A- 1 091 359
- US-A- 5 339 279
- US-A- 5 748 530
- US-A- 5 822 248
- US-B1- 6 504 765
- MASANORI HAYASHIKOSHI: "A DUAL-MODE SENSING SCHEME OF CAPACITOR-COUPLED EEPROM CELL" IEEE JOURNAL OF SOLID-STATE CIRCUITS, IEEE INC. NEW YORK, US, Bd. 27, Nr. 4, 1. April 1992 (1992-04-01), Seiten 569-573, XP000296712 ISSN: 0018-9200

## Beschreibung

Die Erfindung betrifft ein Verfahren zum Auslesen von UCP(Uniform Channel Program)-Flash Memory Zellen, wobei mittels eines jeweiligen Select-Signales auf einer jeweiligen Sektor-Select-Leitung lokale Bitleitungen ausgewählt werden, indem die jeweilige lokale Bitleitung über einen jeweiligen Sektor-Select-Auswahltransistor, der mit seinem Gate an der Sektor-Select-Leitung angeschlossenen ist, an eine jeweilige Globale Bitleitung schaltet.

Die Anforderung an die Entwicklung und Bereitstellung von Speicherschaltkreisen ist durch den anhaltenden Trend nach höherer Speicherdichte und nach höheren Schreib/Lese-Geschwindigkeiten bei geringem Energieverbrauch geprägt.

Beim Stand der Technik ist zu erkennen, dass sich bisher Innovationen stärker im Bereich der Technologie der Speicher durchsetzten, aber weniger die Grundstruktur der bekannten Einheitsspeicherzelle zum Gegenstand haben.

Bei der üblichen Grundstruktur der UCP-Flash Memory Zellen wird die enthaltende digitale Information durch Ladungsspeicherung auf einem Floating-Gate festgehalten.

So ist das Floating-Gate eines solchen Speicherzellen-Transistors über ein Control-Gate einer Wortleitung zugeordnet.

Liegt der Pegel dieser Signalleitung auf LOW, sind die Speichertransistoren für Schreib- und Lesefunktionen nicht selektiert.

Wird bei einer vorliegenden Selektion der Speichertransistoren das Auslesen eines selektierten Speichertransistors betrieben, der mit einer einen HIGH-Pegel repräsentierenden Speicherladung belegt ist, fließt durch den zwischen seinem Drain und seinem Source ausgebildeten Kanal ein statischer Lesestrom.

Im anderen Fall, beim Auslesen eines selektierten Speicher-transistors, der mit einer einen LOW-Pegel repräsentierenden Speicherladung belegt ist, wird der Kanal zwischen seinem Drain und seinem Source nicht ausgebildet und es fließt kein oder ein sehr geringer statischer Lesestrom.

Beim Stand der Technik erfolgt das Auslesen der jeweiligen Speicherzelle bei festen Potenzialen von Source und Drain des Speicherzellen-Transistors, wobei die Source- und Drain-Anschlüsse der Speicherzellen-Transistoren innerhalb einer Bitspalte über eine jeweilige Bit-Leitung parallelgeschaltet sind.

Die beiden Bit-Leitungen weisen Kontaktierungen auf, damit diese auf die notwendigen festen Potenziale gelegt werden können. Im Gegensatz zu anderen Speicherkonzepten, bei denen Source-Leitungen verschiedener Bitspalten auf ein gemeinsames Potenzial gelegt werden können, ist dies beim UCP-Speicherkonzept nicht möglich.

Dadurch fließt ein resultierender statischer Lese-Strom auf den jeweiligen Bit-Leitungen. Die auftretende Größe des statischen Lesestroms repräsentiert die logischen Pegel der Speicherbelegung.

Hieraus ist ersichtlich, dass beim Stand der Technik zum Auslesen der Speicherbelegung der UCP-Flash Memory Zellen zwei Bitleitungen (für Drain und Source) notwendig sind. Diese Zelle ist deshalb in ihrer Minimalabmessungen auf das Zweifache des Metallabstandes in Richtung der Wortleitung begrenzt.

Um diese Einschränkung der Speicherplatznutzung zu minimieren, verwenden die gegenwärtigen UCP Konzepte ausgereizte Metall Design Regeln, bei Entwurf und Fertigung kleiner Zellgrößen.

Zusätzlich wird die kritische Situation beim Design der Zelle erhöht, wenn die erforderlichen Kontaktierungen realisiert werden, um die nötigen Potenziale an den beiden Bit-leitungen anzulegen.

Dies alles bringt das UCP Konzept gegenüber anderen Konzepten bei sehr großen Speichern in einen Konkurrenznachteil.

Es sind daher starke Bestrebungen dahingehend ausgeprägt, Bitleitungen einzusparen. So haben D. Shum et. Al. in der Patentschrift US 6 327 182 vorgeschlagen, die Metallschichten, die für die Bitleitungen verwendet werden, übereinander zu legen.

Dieses Verfahren ist jedoch für die Verringerung der Zellengröße ungeeignet, da die Designregeln (DR) für die dort aufgezeigten gestapelten Vias wesentlich engere Toleranzen erforderlich machen, als die DR für nebeneinander liegende Metallschichten.

Dies macht, wegen der damit verbundenen geringeren Ausbeute, die hierbei zu erwarten ist, den Erfolg der Platzeinsparung ziemlich unwahrscheinlich. US-5-822-248 offenbart die merkmale des Obergriffs des Anspruchs 1.

Daher besteht die erfindungsgemäße Aufgabenstellung darin, die Speicherdichte zu erhöhen, indem die Verringerung der Zellengröße durch Veränderungen der Struktur der Speicherzelle vorgenommen wird, die auch grundlegend andere Lese-Verfahren als das übliche Lesestrom-Verfahren für die Ermittlung der Speicherbelegung einbezieht.

Die Erfindung ist mit Anspruch 1 definiert.

Die erfindungsgemäße Lösung der Aufgabenstellung wird dadurch erreicht, dass im Falle der ausgewählten lokalen Bit-leitungen ein, durch ein jeweiliges Lesepotenzial über eine Wort-Leitung an seinem Gate angesteuerter Speicherzellen-transistor in einem nachfolgend beschriebenen Auslesevorgang ausgelesen wird.

So ist der jeweilige Speicherzellentransistor einer Bit-Spalte zugehörig, die aus jeweils paarweise mit ihren Drain- und Source-Anschlüssen parallel geschalteten Speicherzellen-transistoren besteht. Hierbei sind einerseits die Drain-Anschlüsse der Speicherzellentransistoren über die lokale Bitleitung verbunden. Anderseits liegen deren Source-Anschlüsse nicht an einem festen Potenzial.

Beim Auslesevorgang wird eine von der Größe der auf dem Floating-Gate des angesteuerten Speicherzellentransistors gespeicherten Ladung abhängige kapazitive Belastung der lokalen Bitleitung erzeugt.

Dabei wird je nach Größe der besagten kapazitiven Belastung der lokalen Bitleitung auf dieser ein resultierendes Auslese-Signal bereitgestellt, das von einem an der lokalen Bit-leitung angeschlossenen Leseblock als gültig auszugebender LOW- bzw. HIGH-Pegel eines Bit-Signales bewertet wird.

Das Bit-Signal korrespondiert mit der Bit-Belegung des Speicherzellen-Transistors, die durch die Größe der auf dem Floating-Gate gespeicherten Ladung repräsentiert wird.

Diese Lösung zielt darauf ab, dass bei einer Veränderung der Struktur der Speicherzelle zur Verringerung der Zellengröße auch ein grundlegend anderes Lese-Verfahren zur Anwendung kommt und somit das Lesen der Speicherbelegung der Speichertransistoren mit kapazitiven Mitteln erfolgt. Dabei weist das Source-Potenzial des jeweilig auszulesenden Speicher-transistors ein schwimmendes Potenzial auf.

Auf diese Weise wird vermieden, dass ein festes Potenzial am Source-Anschluss *notwendig ist* und dass dadurch jeweils eine metallische Source-Leitung(als Lese-Leitung) *bereitzustellen ist* bzw. es wird vermieden, dass bei Ausführung einer solchen Source-Leitung als vergrabene Leitung auch flächenaufwendige Kontaktierungen vorzunehmen sind.

Durch das kapazitive Auslesen vorwiegend der jeweiligen Source-Masse-Kapazität kann das zugehörige Potenzial am jeweiligen Source Anschluss des Speichertransistors schwimmend sein. Da bei dieser Lösung kein ständig fließender Lesestrom ausgewertet wird, ist die Kapazitätsmessung außerdem energiesparend.

So bietet sich mit dieser energiesparenden Wirkung dieses Kapazitätsmessverfahren zur Ermittlung der Bitbelegung des Speichertransistors zusätzlich in Anwendungen von Low-Power Schaltkreisen an.

Somit sind Lese-Operationen realisierbar, die sehr wenig energieaufwändig sind, da beim Lesen der Speicherbelegung eines jeweiligen Speichertransistors transient nur eine kapazitive Last getrieben werden braucht.

Dies bedeutet, dass im Falle der HIGH-Belegung (der Speichertransistor ist durchgeschaltet d.h. der Kanal zwischen Drain Source ist ausgebildet) die parasitäre Drain/Masse-, Kanal/Masse- und die Source/Masse-Kapazität, andernfalls nur die Drain/Masse-Kapazität als transient zu treibende Last anzusehen ist.

Weiterhin ist die mit diesem Verfahren erreichbare UCP-Zellgröße in ihrer Leistungsfähigkeit mit Spitzenwerten anderer Zell-Strukturen ebenbürtig.

Günstig ist, dass bei einer solchen UCP-Zelle die üblichen Programmier-und Lösch-Verfahren einsetzbar sind.

Auch die parallele Anwendung konventioneller und UCP-Zellen mit der erfindungsgemäßen Lösung sind im gleichen Chip realisierbar.

Beim Entwurf von Speicherschaltkreisen von UCP-Zellen der erfindungsgemäßen Lösung sind unterschiedliche, an sich gegeneinander stehende Anwendungsanforderungen z. B. Lesegeschwindigkeit gegen Speicherdichte gut austausch- und abstimmbar. Speziell diese Anwendungsanforderungen werden beide durch eine einheitliche Architektur effektiv unterstützt.

Eine Ausführung der erfindungsgemäßen Lösung wird dadurch erreicht, dass während des Auslesevorgangs das jeweilige Lesepotenzial der Wort-Leitung in einer Anzahl diskreter Schritte variiert wird.

Es wird für jeden diskreten Schritt des Lesepotenzials ein solches resultierend sich einstellendes Auslese-Signal ermittelt, welches ebenso unterschiedliche diskrete Pegel aufweist.

Nachfolgend wird die Gesamtheit der diskreten Pegel des Lese-Signals mittels geeigneter Kodierung von dem an der lokalen Bitleitung angeschlossenen Leseblock als gültig auszugebende LOW- bzw. HIGH-Pegel eines Mehrfach-Bit-Signals bewertet, welches mit der Mehrfach-Bit-Belegung des Speicherzellen-Transistors korrespondiert.

Hierbei wird die Mehrfach-Bit-Belegung durch die Größe der auf dem Floating-Gate gespeicherten Ladung repräsentiert.

Die mehrstufigen Werte der gemessenen kapazitiven Belastung je Speichertransistor können entweder direkt als Mehrfach-Bit-Belegung dazu beitragen das Speichervolumen zu erhöhen, oder sie können durch entsprechende Codierungsauswertung die bewertete HIGH/LOW-Pegelzuordnung mit einer hohen Störsicherheit versehen, indem erkannte Pegel, die nicht eindeutig HIGH/LOW-Pegeln zugeordnet werden können und somit einer "verbotenen Zone" der Binärwert-Zuordnung zugehören, verifiziert werden (z.B. durch erneutes Lesen der Speicherbelegung etc.).

Eine Variante der Ausführung der erfindungsgemäßen Lösung wird dadurch erreicht, dass ein der Bit-Spalte zugehöriges erstes und zweites Speicherzellen-Transistorpaar, deren Transistoren jeweils paarweise an den Drain- und Source-Anschlüssen parallel geschaltet sind, mit ihren jeweiligen gemeinsamen Source-Anschlüssen mit einer gemeinsamen Source-Anschlussverbindung verbunden sind.

Hierbei ist diese gemeinsame Source-Anschlussverbindung ebenfalls nicht mit einem festen Potenzial verbunden.

Weiterhin werden mit der gemeinsamen Source-Anschlussverbindung die jeweils zum ersten und zweiten Speicherzellen-Transistorpaar zugehörigen ersten und zweiten Source-Masse-Kapazitäten parallel geschaltet.

Bei dieser Lösung werden die nicht selektierten Speicher-Transistoren mit ihren Source/Masse-Kapazitäten mit der Source/Masse-Kapazität des selektierten Speicher-Transistors parallel geschaltet. Damit wird die Gesamt-Kapazität der kapazitiven Belastung der Bitleitung beim jeweiligen Lesen der Bit-Belegung des selektierten Speicher-Transistors erhöht.

Ein vorzugsweise besseres Auslesen der Bit-Belegung des selektierten Speicher-Transistors ist bei dieser erfinderischen Lösung mit einem differentiellen Lesen zu erreichen. Dabei wird eine Referenz-Bitleitung verwendet, um Gleichtakt-Störungen auszublenden.

Hierbei kann als Referenz-Bitleitung eine beliebige selektierte Bitleitung aus dem Speicher verwendet werden und es wird eine zugehörige Speicherzelle ausgewählt, deren Kanal geschlossen ist. Auf diese Weise liegt als Referenz eine Speicherzelle vor, bei der die kapazitive Belastung der Bit-leitung bei nicht ausgebildetem Kanal bekannt ist und kann zum Vergleich bei der Differenzmessung herangezogen werden.

Eine weitere Ausführung der erfindungsgemäßen Lösung wird dadurch erreicht, dass die gemeinsame Source-Anschlussverbindung ohne äußeren Anschluss als vergrabene Bitleitung ausgeführt wird.

Die Erfindung soll nachfolgend anhand eines Ausführungsbeispiels näher erläutert werden. In der zugehörigen Zeichnungsfigur wird ein Speicherbereich eines UCP-Flash-Memory 1 gezeigt.

Beim Auslesen wird mittels eines jeweiligen Select-Signales auf einer jeweiligen Sektor-Select-Leitung 2 eine lokale Bitleitung 10 ausgewählt. Die jeweilige lokale Bitleitung 10 wird über einen jeweiligen Sektor-Select-Auswahltransistor 6, der mit seinem Gate an der Sektor-Select-Leitung 2 angeschlossenen ist, an eine jeweilige Globale Bitleitungen 5 geschaltet.

Zu einer Bit-Spalte 15 gehören ein erstes Speicherzellen-Transistorpaar 11 und ein zweites Speicherzellen-Transistorpaar 12. Diese bestehen aus Speicherzellentransistoren, die jeweils paarweise mit ihren Drain- und Source-Anschlüssen parallel geschalteten sind, wobei deren Drain-Anschlüsse über die lokale Bitleitung 10 verbunden sind und deren Source-Anschlüsse nicht an einem festen Potenzial liegen.

Wird im Falle der ausgewählten lokalen Bitleitungen 10 der Speicherzellentransistor, durch ein jeweiliges Lesepotenzial 13 über eine Wort-Leitung 3 an seinem Gate angesteuert, wird ein Auslesevorgang dadurch realisiert, dass eine von der Größe der auf dem Floating-Gate des angesteuerten Speicherzellentransistors gespeicherten Ladung abhängige kapazitive Belastung der lokalen Bitleitung 10 erzeugt wird.

Je nach Größe der kapazitiven Belastung der lokalen Bitleitung 10 wird auf dieser ein resultierendes Auslese-Signal 14 bereitgestellt, welches von einem an der lokalen Bitleitung 10 angeschlossenen Leseblock 16 als gültig auszugebender LOW- bzw. HIGH-Pegel eines Bit-Signales bewertet wird.

Dieses Bit-Signal korrespondiert mit der Bit-Belegung HIGH/LOW des Speicherzellen-Transistors, welche durch die Größe der auf dem Floating-Gate gespeicherten HIGH/LOW Ladung repräsentiert wird.

Abhängig von der gespeicherten Ladung auf dem Floating-Gate wird bei der angelegten Lesespannung ein Kanal ausgebildet oder nicht. Im ersteren Fall ist eine solche Kapazität messbar, die im wesentlichen aus einer Drain/Masse-Kapazität (nicht weiter dargestellt), Kanal/Masse-Kapazität und einer ersten bzw. zweiten Source/Masse-Kapazität 8;9 gebildet wird. Wird kein Kanal ausgebildet, kann nur die Drain/Masse-Kapazität gemessen werden.

Bei diesem erfindungsgemäßen Leseverfahren werden vorzugsweise Spannungen ausgewertet, auf keinen Fall jedoch statische Ströme.

In einem Ausführungsbeispiel des Leseverfahrens wird der selektierte Speicherzellen-Transistor mit einer hohen Lesespannung geöffnet und die lokale Bitleitung 10 auf ein erstes Potenzial gebracht.

Anschließend wird die Lesespannung auf Null zurückgenommen und danach wird die lokale Bitleitung 10 auf ein zweites Potenzial gebracht und danach hochohmig geschaltet.

Die eigentliche Lesespannung wird angelegt und der Spannungshub an der lokalen Bitleitung 10 gemessen. Da nur der Spannungshub gemessen wird und die Drain/Masse-Kapazität ständig als kapazitive Belastung der lokalen Bitleitung 10 wirksam ist, wird somit nur die Wirkung der ersten bzw. zweiten Source/Masse-Kapazität 8;9 gemessen.

Im Leseblock 16 werden die ausgelesen Pegel dekodiert, wobei ein großer Spannungshub einen geöffneten Kanal als HIGH identifiziert und ein kleiner Spannungshub einen geschlossenen Kanal als LOW identifiziert.

Somit werden vom angeschlossenen Leseblock 16 die als gültig auszugebende LOW- bzw. HIGH-Pegel eines Bit-Signales bewertet. Diese LOW- bzw. HIGH-Pegel korrespondieren mit der Bit-Belegung des Speicherzellen-Transistors, welche durch die Größe der auf dem Floating-Gate gespeicherten Ladung repräsentiert werden.

### Bezugszeichenliste

- 1: UCP-Flash-Memory
- 2: Sektor-Select-Leitung
(Anschaltung der globalen Bitleitung an die lokale Bitleitung)
- 3: Wortleitung
- 4: Masseleitung (Bulk-Potenzial)
- 5: Globale Bitleitung
- 6: Sektor-Select-Auswahltransistor
- 7: gemeinsame Source-Anschlussverbindung
- 8: erste Source-Masse-Kapazität
- 9: zweite Source-Masse-Kapazität
- 10: lokale Bitleitung (gemeinsame Drain-Anschlussleitung der Speicherzellen-Transistoren einer Bitspalte)
- 11: erstes Speicherzellen-Transistorpaar
- 12: zweiter Speicherzellen-Transistorpaar
- 13: Lesepotenzial
- 14: Auslese-Signal
- 15: Bit-Spalte
- 16: Leseblock

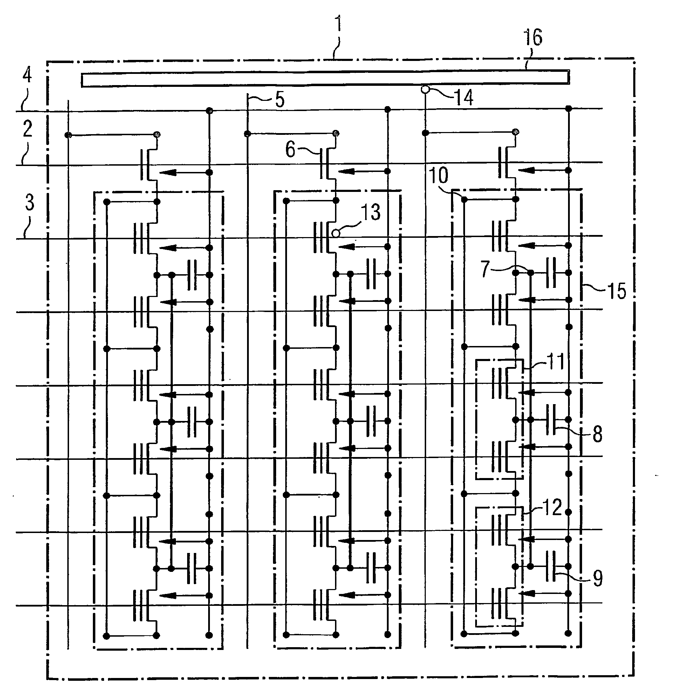

## Patentansprüche

1. Verfahren zum Auslesen von Uniform Channel Program Flash Memory Zellen, wobei mittels eines jeweiligen Select-Signales auf einer jeweiligen Sektor-Select-Leitung lokale Bitleitungen ausgewählt werden, indem die jeweilige lokale Bitleitung über einen jeweiligen Sektor-Select-Auswahltransistor, der mit seinem Gate an der Sektor-Select-Leitung angeschlossenen ist, an eine jeweilige Globale Bitleitung schaltet wobei,
im Falle der ausgewählten lokalen Bitleitungen (10) ein, durch ein jeweiliges Lesepotenzial (13) über eine Wort-Leitung (3) an seinem Gate angesteuerter Speicherzellentransistor, welcher einer Bit-Spalte (15) zugehörig ist, die aus jeweils paarweise mit ihren Drain- und Source-Anschlüssen parallel geschalteten Speicherzellentransistoren besteht und deren Drain-Anschlüsse über die lokale Bitleitung (10) verbunden sind wobei **dadurch gekennzeichnnet dass**, deren Source-Anschlüsse nicht an einem festen Potenzial liegen, **dadurch** in einem Auslesevorgang ausgelesen wird,
dass eine von der Größe der auf dem Floating-Gate des angesteuerten Speicherzellentransistors gespeicherten Ladung abhängige kapazitive Belastung der lokalen Bitleitung (10) erzeugt wird, wobei je nach Größe der besagten kapazitiven Belastung der lokalen Bitleitung (10) auf dieser ein resultierendes Auslese-Signal (14) bereitgestellt wird, das von einem an der lokalen Bitleitung (10) angeschlossenen Leseblock (16) als gültig auszugebender LOW- bzw. HIGH-Pegel eines Bit-Signales bewertet wird, welches mit der Bit-Belegung des Speicherzellen-Transistors korrespondiert, die durch die Größe der auf dem Floating-Gate gespeicherten Ladung repräsentiert wird.

2. Verfahren nach Anspruch 1, **dadurch gekennzeichnet, dass** während des Auslesevorgangs das jeweilige Lesepotenzial (13) der Wort-Leitung (3) in einer Anzahl diskreter Schritte variiert wird, wobei für jeden diskreten Schritt des Lesepotenziales (13) ein solches resultierend sich einstellendes Auslese-Signal (14) mit ebenso diskreten Pegeln ermittelt wird und nachfolgend die Gesamtheit der diskreten Pegel des Lese-Signal (14) mittels geeigneter Kodierung von dem an der lokalen Bitleitung (10) angeschlossenen Leseblock (16) als gültig auszugebende LOW- bzw. HIGH-Pegel eines Mehrfach-Bit-Signals bewertet wird, welches mit der Mehrfach-Bit-Belegung des Speicherzellen-Transistors korrespondiert, die durch die Größe der auf dem Floating-Gate gespeicherten Ladung repräsentiert wird.

3. Verfahren nach Anspruch 1 oder Anspruch 2, **dadurch gekennzeichnet, dass** ein der Bit-Spalte (15) zugehöriges erstes und zweites Speicherzellen-Transistorpaar (11),(12), deren Transistoren jeweils paarweise an den Drain- und Source-Anschlüssen parallel geschaltet sind, mit ihren jeweiligen gemeinsamen Source-Anschlüssen mit einer gemeinsamen Source-Anschlussverbindung (7) verbunden sind, wobei diese nicht mit einem festen Potenzial verbunden ist,
dass mit der gemeinsamen Source-Anschlussverbindung (7) die jeweils zum ersten und zweiten Speicherzellen-Transistorpaar (111),(12) zugehörigen ersten und zweiten Source-Masse-Kapazitäten (8),(9) parallel geschaltet werden.

4. Verfahren nach Anspruch 3, **dadurch gekennzeichnet, dass** die gemeinsame Source-Anschlussverbindung (7) ohne äußeren Anschluss als vergrabene Bitleitung ausgeführt wird.

## Claims

1. Method for the read-out of Uniform Channel Program flash memory cells, local bit lines being selected by means of a respective select signal on a respective sector select line by virtue of the respective local bit line switching to a respective global bit line via a respective sector select selection transistor, which is connected to the sector select line by its gate, wherein, in the case of the selected local bit lines (10), a memory cell transistor which is driven by a respective read potential (13) at its gate via a word line (3) and which is associated with a bit column (15), which comprises memory cell transistors respectively connected in parallel in pairs by their drain and source terminals and the drain terminals of which are connected via the local bit line (10), **characterized in that** the source terminals thereof are not at a fixed potential, is read in a read-out operation by a procedure whereby
a capacitive loading of the local bit line (10) dependent on the magnitude of the charge stored on the floating gate of the driven memory cell transistor is generated, a resulting read-out signal (14) being provided on the local bit line (10) depending on the magnitude of the aforementioned capacitive loading of said local bit line, which read-out signal is assessed by a read block (16) connected to the local bit line (10) as LOW or HIGH level - to be output in valid fashion - of a bit signal which corresponds to the bit occupancy of the memory cell transistor, which is represented by the magnitude of the charge stored on the floating gate.

2. Method according to Claim 1, **characterized in that**, during the read-out operation, the respective read potential (13) of the word line (3) is varied in a number of discrete steps, in which case, for each discrete step of the read potential (13), such a read-out signal (14) established in a resultant manner with likewise discrete levels is determined and then the totality of the discrete levels of the read signal (14) is assessed, by means of suitable coding, by the read block (16) connected to the local bit line (10) as LOW or HIGH levels - to be output in valid fashion - of a multiple bit signal which corresponds to the multiple bit occupancy of the memory cell transistor, which is represented by the magnitude of the charge stored on the floating gate.

3. Method according to Claim 1 or Claim 2, **characterized in that** a first and second memory cell transistor pair (11), (12) which are associated with the bit column (15) and the transistors of which are in each case connected in parallel in pairs at the drain and source terminals are connected by their respective common source terminals to a common source terminal connection (7), the latter not being connected to a fixed potential,
**in that** the first and second source-ground capacitances (8), (9) respectively associated with the first and second memory cell transistor pairs (11), (12) are connected in parallel with the common source terminal connection (7).

4. Method according to Claim 3, **characterized in that** the common source terminal connection (7) is embodied as a buried bit line without external connection.

## Revendications

1. Procédé de lecture de cellules de mémoire flash dites "Uniform Channel Program", dans lequel au moyen d'un signal de sélection, des conducteurs locaux de bit sont sélectionnés sur un conducteur respectif de sélection de secteur en raccordant à un conduit global de bit respectif le conducteur de bit local par l'intermédiaire d'un transistor respectif de sélection de secteur raccordé par sa grille au conducteur de sélection de secteur,
tandis que dans le cas des conducteurs locaux de bit (10) sélectionnés, un transistor de cellule de mémoire commandé par sa grille par un potentiel de lecture (13) respectif par l'intermédiaire d'un conducteur de mot (3) et associé à un intervalle (15) entre bits constitué de transistors de cellule de mémoire raccordés par paires parallèles par leurs bornes de drain et de source et dont les bornes de drain sont reliées par l'intermédiaire du conducteur local de bit (10) est lu dans une opération de lecture,
**caractérisé en ce que**
leurs bornes de source ne sont pas situées à un potentiel fixe,
**en ce qu'**une charge capacitive du conducteur local de bit (10) est formée en fonction de la taille de la charge accumulée sur la grille flottante du transistor de cellule de mémoire commandée, un signal de lecture (14) résultant étant appliqué sur le conducteur local de bit (10) en fonction de la taille de ladite charge capacitive et étant évalué comme délivrant validement un niveau BAS ou un niveau HAUT de signal de bit par un bloc de lecture (16) raccordé au conducteur local de bit (10), ce signal de bit correspondant à l'occupation, représentée par la taille de la charge conservée sur la grille flottante, du transistor de cellule de mémoire par les bits.

2. Procédé selon la revendication 1, **caractérisé en ce que** pendant l'opération de lecture, le potentiel de lecture (13) respectif du conducteur de mot (3) est modifié en un certain nombre d'étapes distinctes, tandis que pour chaque étape distincte du potentiel de lecture (13), un signal de lecture (14) qui s'établit en résultat de ce potentiel et qui présente des niveaux également distincts est déterminé, tous les niveaux distincts du signal de lecture (14) étant ensuite évalués au moyen d'un codage approprié comme niveau BAS ou niveau HAUT à émettre validement d'un signal de bits multiples par le bloc de lecture (16) raccordé au conducteur local de bit (10), ce signal correspondant à l'occupation, représentée par la taille de la charge conservée sur la grille flottante, du transistor de cellule de mémoire par plusieurs bits.

3. Procédé selon la revendication 1 ou la revendication 2, **caractérisé en ce qu'**une autre première et une deuxième paire (11), (12) de transistors de cellule de mémoire qui font partie de l'intervalle entre bits (15) et dont les transistors sont tous raccordés en paires par les bornes de drain et de source sont reliées par leur borne de source commune à une liaison commune (7) de bande de source qui n'est pas reliée à un potentiel fixe et **en ce que** la première et la deuxième capacité source-masse (8), (9) associées respectivement à la première et à la deuxième paire (11), (12) de transistors de cellule de mémoire sont raccordées en parallèle à la liaison commune (7) de borne de source.

4. Procédé selon la revendication 3, **caractérisé en ce que** la liaison commune (7) de borne de source est réalisée sans borne extérieure, sous la forme d'un conducteur de bit en tranchée.
